# EUROPEAN PATENT APPLICATION

(11) **EP 4 576 483 A1**
(43) Date of publication of application: **25.06.2025**
(21) Application number: 23218631.2
(22) Date of filing: 20.12.2023
(51) Int. Cl.: H02J 3/36, H02J 3/38, H01L 31/042, H02J 1/08, H02S 10/10

(54) **SYSTEM FOR THE GENERATION AND TRANSMISSION OF HIGH-VOLTAGE DIRECT CURRENT**

(71) Applicant: AIT Austrian Institute of Technology GmbH, 1210 Wien (AT)
(72) Inventor: Berger, Karl, 2511 Pfaffstätten (AT); Kubicek, Bernhard, 1200 Wien (AT)
(74) Representative: Schwarz & Partner Patentanwälte GmbH

(57) **Abstract**

The invention relates to a system comprising a high-voltage direct current (HVDC) transmission line (10) carried by pylons (20), a high-voltage PV generator (30) connected to the high-voltage direct current transmission line (10), a power conversion equipment (40) with an input connected to the high-voltage direct current transmission line (10) and an output connectable to an AC or DC grid (50), comprising at least one of a point-source, a load and a network. A high-voltage output of the high-voltage PV generator (30) is directly connected (11) to a transmission pole (12) of the high-voltage direct current transmission line (10).

## Description

The present invention relates to a system, comprising a high-voltage direct current (HVDC) transmission line carried by pylons, a high-voltage (HV) photovoltaic (PV) generator connected to the high-voltage direct current transmission line, a power conversion equipment (PCE) with an input connected to the high-voltage direct current transmission line and an output connectable to an AC or DC grid, comprising at least one of a point-source, a load and a network.

In the light of unquestionable signs for climate change, and with the global energy system as a main source for greenhouse gas emissions, a transformation into an efficient, reliable, and renewable based energy system is necessary. Upcoming megatrends of this transformation include a growing electrification rate, use of volatile energy sources - with PV as the new backbone - in the energy system, but with the generation not always located in the area where needed. Therefore, beside storage and sector-coupling, long-distance transmission of electrical energy is indispensable. As Photovoltaic Power Systems (PVPS) are built with increasing system size and power, this pushes the conventional setup, using fully electrically insulated components in close contact to ground, connected to string or centralized PCE, with Low-Voltage (LV) components to its limits, i.e., 1000 V AC r.m.s, and 1500 V DC for LV. Proposed standardization projects within IEC TC82 (PV systems) and TC99 (HV insulation coordination) to extend PVPS component requirements for DC voltages up to 3 kV is a gradual change only. To overcome existing PVPS concepts, using mainly fully electrically insulated components in close contact to ground, is an essential next step.

US 8212408 B2 discloses an apparatus for collecting electric power generated by a high voltage DC source and delivering the power to an AC transmission network. Moreover, the apparatus comprises a high voltage DC power transmission link connected to the high voltage DC source and an inverter connected to the AC transmission network. The high voltage DC power transmission link produces extra costs, increases the system complexity, and leads to a loss in power conversion efficiency.

The objective of the invention is to provide a system for the photovoltaic generation and transmission of high-voltage direct current, which is more cost efficient, less complex, and more flexible and efficient at the same time.

The objective is solved by providing a system as defined in claim 1 and a high-voltage PV generator as defined in claim 12. Preferred embodiments of the invention are defined in the dependent claims, the description and the drawings.

According to the invention, a high-voltage output of the high-voltage PV generator is directly connected to a pole of the high-voltage direct current transmission line. This direct connection of the PV-generator with the HVDC line without a PCE directly integrates transmission and production. As these connections are far away from the pylons and any other conductive components in contact to ground, it is not necessary to insulate these connections.

In a preferred embodiment, the high-voltage PV generator comprises at least one row of PV modules, wherein the PV modules are directly serially connected along a meandering arrangement. In a further preferred embodiment, the high-voltage PV generator comprises two rows of PV modules, wherein the two rows are connected in parallel. Because the series resistance losses are linear with the series resistance but quadratic in current, such a series-parallel connection decreases series resistance losses, when compared with a PV generator of the same area and power with a sole series connection and the double string current.

In a preferred embodiment, each row or the two parallelly connected rows form one array of the high-voltage PV generator, respectively, wherein the high-voltage PV generator comprises at least two arrays, wherein the arrays are connected in a mirror-symmetric arrangement with regards to a direct current generator field.

In a preferred embodiment, the PV modules are electrically connected via bare conductors. The voltage within the PV-generators changes gradually from the positions adjacent to the pylons (the low-voltage end of the PV-generators) to the full positive or negative line voltage (the high-voltage end of the PV-generators, directly connected to the positive or negative poles). It is therefore advantageous if the PV modules are electrically connected via bare air-insulated conductors instead of using costly additional insulation materials. A bare conductor may further serve as sub-conductor, forming a conductor bundle.

In a preferred embodiment, the PV modules are at least based on one of the following cell and interconnect technologies: bifacial, thin film, shingled, glued, soldered, welded. A bifacial PV module converts light to DC electricity on both the front and back of the PV modules. Thin-film based PV modules are made of thin layers of strongly light-absorbing semiconductor materials. These materials mainly include cadmium telluride, copper indium gallium selenide, amorphous silicon, and gallium arsenide. In a shingled PV cell array, the PV cells are positioned so that the gaps between them are minimal. Shingling overlap or almost zero-gap interconnects may be achieved by glueing with electric conductive adhesives, or by means of soldered or welded metallic interlayers. The same interconnection technologies may also be applied to connecting PV modules.

In a preferred embodiment, the single PV modules and/or the rows are directly connected to the poles of the high-voltage direct current transmission line. In addition to the advantage of using bare air-insulated conductors instead of using costly additional insulation materials as discussed above, this direct connection allows for control of the PV-generator's power as well as of the transmission power by the PCE at the end of the HVDC line: the voltage differences to ground define the operating point of the PV-generators, and the voltage differences between both ends of the same pole define the transmitted power.

In a preferred embodiment, the system further comprises additional direct current sources at low voltage ends of the PV arrays. These additional DC sources provide the ability to add positive or negative voltage or to inject additional direct current at the neutral connection points for maximum power point (MPP) fine tuning. Thus, it is possible to compensate e.g. an assumed lower voltage gradient due to lower insolation at certain PV arrays.

In a preferred embodiment, the single PV modules and/or the rows are connected to independent power lines or ropes, wherein the independent power lines or ropes are mechanically and/or electrically connected to the pylons directly or by means of spacing insulators.

In a preferred embodiment, the output of the power conversion equipment is connected to a high-voltage network. The high-voltage network may be an additional point-source at one end of the HVDC transmission and generation system. Alternatively, the high-voltage network may be a source and/or a load on both ends of the HVDC transmission and generation system. Furthermore, the high-voltage network may be DC or AC.

In a preferred embodiment, the power conversion equipment is a direct current to direct current inverter or a direct current to alternate current converter, favorable in a voltage source converter (VSC) technology, available in a power range capacity from a few MW up to several GW.

According to the invention, a high-voltage PV generator is provided, which is directly connectable to a system according to the invention, wherein the high-voltage PV generator comprises at least one row of PV modules, wherein the PV modules are directly serially connected along a meandering arrangement.

In a preferred embodiment, the high-voltage PV generator comprises two rows of PV modules, wherein the high-voltage PV generator comprises at least two arrays, wherein the arrays are connected in a mirror-symmetric arrangement with regards to a direct current generator field.

In a preferred embodiment, the PV modules of the high-voltage PV generator are electrically connected via bare conductors. A bare conductor may further serve as sub-conductor, forming a conductor bundle.

In a preferred embodiment, the PV modules of the high-voltage PV generator are at least based on one of the following cell and interconnect technologies: bifacial, thin film, shingled, glued, soldered, welded.

The present invention will now be described by way of illustrative examples with reference to the accompanying drawings, in which:
Fig. 1 shows a schematic view of the high-voltage DC transmission and generation system.
Fig. 2 shows a schematic view of a high-voltage PV generator in a single module row zigzag layout.
Fig. 3 shows a schematic view of a high-voltage PV generator in a dual module row zigzag layout.
Fig. 4a shows a schematic view of connected high-voltage PV generators having a negative potential between them.
Fig. 4b shows a schematic view of connected high-voltage PV generators having a positive potential between them.
Fig. 5 shows a schematic view of high-voltage PV generators connected to a unipolar DC transmission line.
Fig. 6 shows a schematic view of several high-voltage PV generators and their corresponding potential distribution.
Fig. 7 shows a schematic view of high-voltage PV generators connected to a high-voltage DC transmission line, corresponding potential distribution and power distribution.
Fig. 8 shows a current-voltage characteristic of a PV generator array for three levels of irradiance.

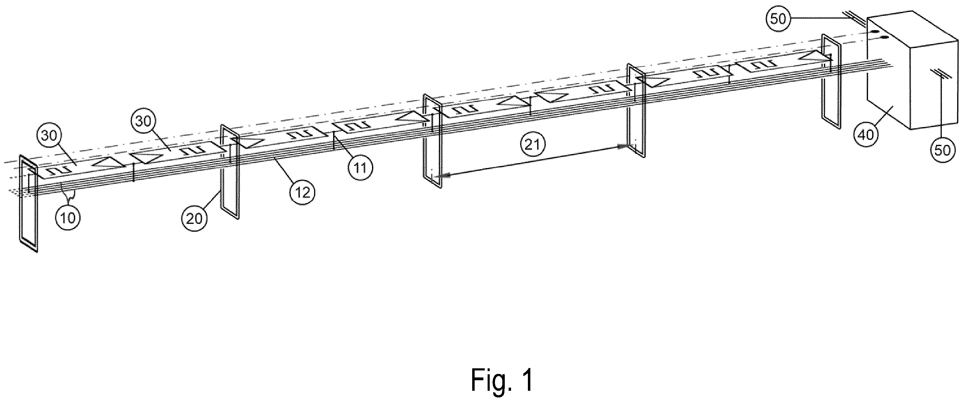

Fig. 1 shows a projected schematic view of the high-voltage DC transmission and generation system. A high-voltage direct current transmission line 10 is carried by pylons 20, which are distanced by a span length 21. A high-voltage PV generator 30 is connected to the high-voltage DC transmission line 10. A power conversion equipment 40 (PCE), comprising one or more electronic valve devices, transformers and/or filters, is connected to an input to the high-voltage DC transmission line 10 and an output is connectable to at least one of a point-source, a load, and a network 50. A high-voltage output of the high-voltage PV generator is directly connected 11 to a pole 12, i.e. a conductor, or bundle of conductors, of a DC line which is intended to be energized under normal use, of the high-voltage DC transmission line 10. The dash-dotted lines represent lightning protective earth wires, which are a conductor connected to earth at some or all supports, which is suspended usually but not necessarily above the line conductors to provide a degree of protection against lightning strokes.

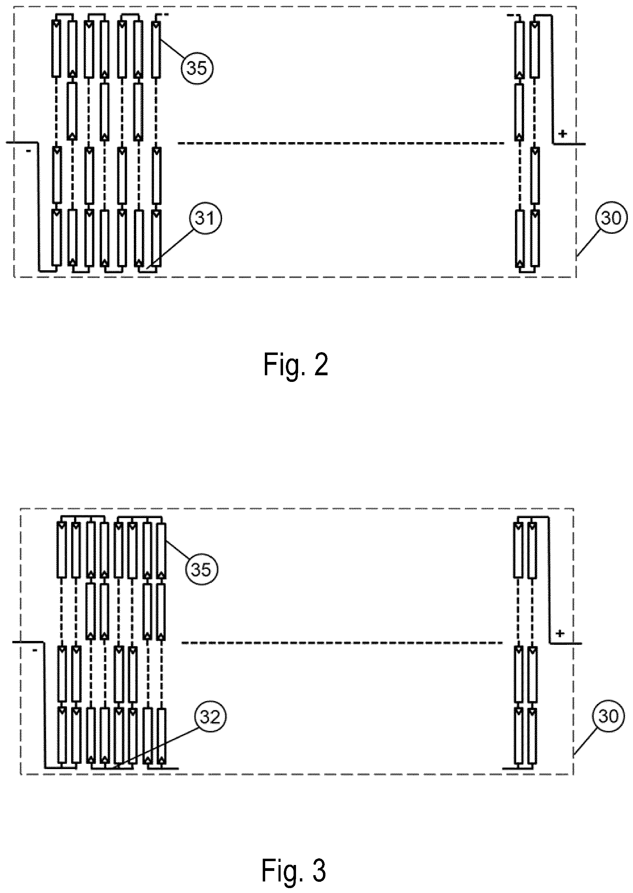

Fig. 2 shows a schematic diagram of a high-voltage PV generator 30 in a single module row zigzag layout. The PV modules 35 are connected in series 31. Fig. 3 shows a similar high-voltage PV generator 30 as in Fig. 2, wherein several PV modules 35 are first connected in series and then in parallel, in order to form a segment of the zigzag meandering arrangement, which is referred to as dual (or, multiple, in case that more than two rows of parallelly connected PV modules 35 form a segment of the zigzag meandering arrangement) module row zigzag layout. The connections within the high-voltage PV generators 30 of either Fig. 2 or Fig. 3 may be realized by using bare conductors, i.e. conductors consisting of a number of individual uninsulated wires laid up together in alternating left- and right-hand helical layers.

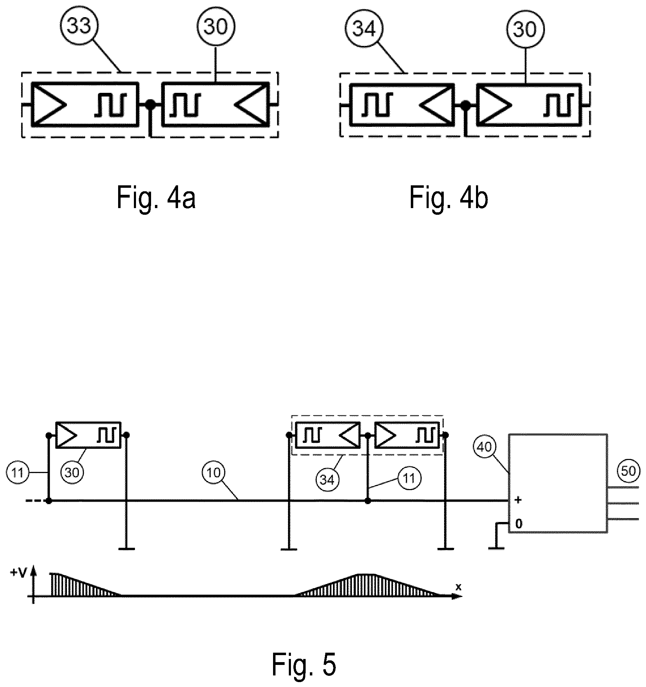

Fig. 4a shows two high-voltage PV generators 30 connected in a mirror-symmetric arrangement 33, having a high negative potential between them. The right-hand high-voltage PV generator 30 in Fig. 4a is a symbolic representation of either high-voltage PV generator 30 depicted in Fig. 2 or Fig. 3. The left-hand high-voltage PV generator 30 is the mirror image of the right-hand one. Fig. 4b shows two high-voltage PV generators 30 connected in a mirror-symmetric arrangement 34, having a high positive potential between them.

The top half of Fig. 5 shows a schematic view of high-voltage PV generators 30 connected to the positive pole of a unipolar DC transmission line 10. Here, both a single high-voltage PV generator 30 as well as two high-voltage PV generators connected in a mirror-symmetric arrangement 34 are used. The high-voltage PV generators 30 are directly connected 11 with their positive ends to the positive pole of the transmission line 10. The bottom half of Fig. 5 shows the spatial distribution of the electric potential of the PV arrays with respect to ground. The large positive electric potential in the middle of the mirror-symmetric arrangement 34 can easily be seen.

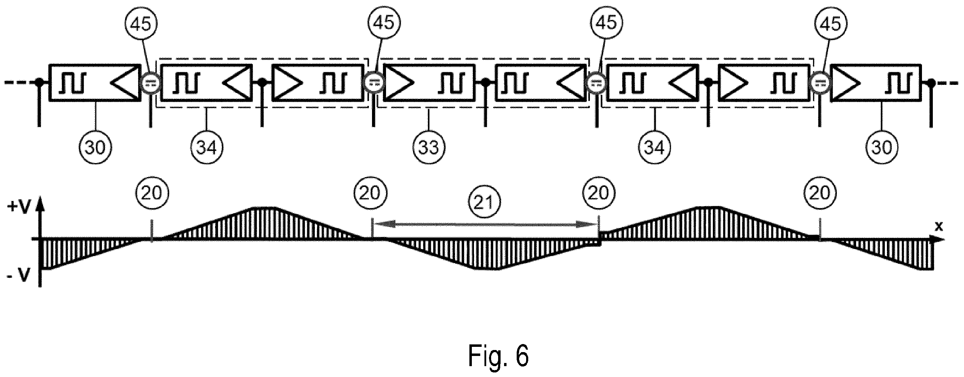

Fig. 6 shows a schematic view of several high-voltage PV generators 30 and their corresponding electric potential distribution. At the low-voltage ends of each high-voltage PV generator 30, an additional DC source 45 is provided. These additional DC sources 45 provide the ability to inject additional direct current at the neutral connection points for maximum power point (MPP) fine tuning. Thus, it is possible to compensate e.g. an assumed lower voltage gradient due to lower insulation at certain PV arrays. Such a voltage gradient can for instance be seen in the electric potential diagram in the bottom half of Fig. 6, below the third additional DC source 45 from the left. The nodes in the electric potential diagram further indicate the span length 21 between the pylons 20.

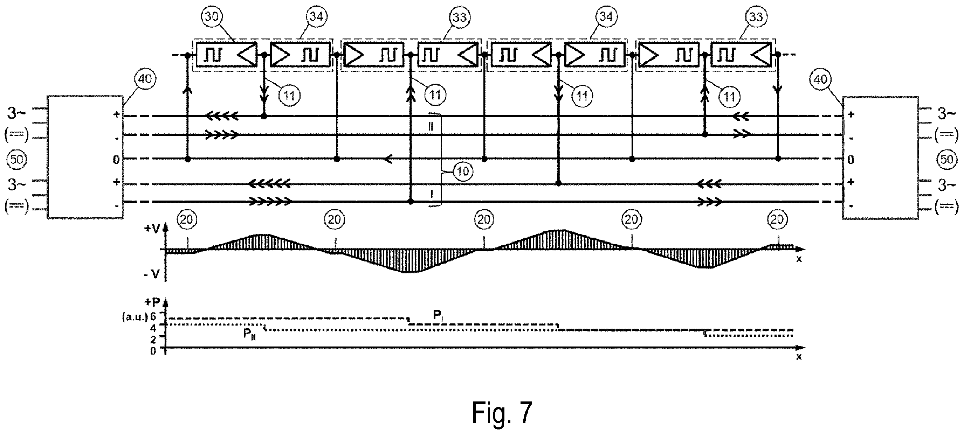

Fig. 7 shows a schematic view of high-voltage PV generators 30 connected to a high-voltage DC transmission line 10, with a corresponding potential distribution and power distribution below the schematic view. The high-voltage PV generators 30 are connected in a mirror-symmetric arrangement 33, 34. The mid-point of the high-voltage PV generators 30 in the positive-potential mirror-symmetric arrangement 34 is connected to the positive pole of the double circuit bipolar high-voltage DC transmission line 10 circuit. Similarly, the mid-point of the high-voltage PV generators 30 in the negative-potential mirror-symmetric arrangement 33 is connected to the negative pole of the double circuit bipolar high-voltage DC transmission line 10 circuit. The two circuits of the high-voltage DC transmission line 10 are indicated with I and II, respectively. The low-voltage ends of the PV arrays are connected to a neutral pole and may include additional DC sources 45 as shown in Fig. 6.

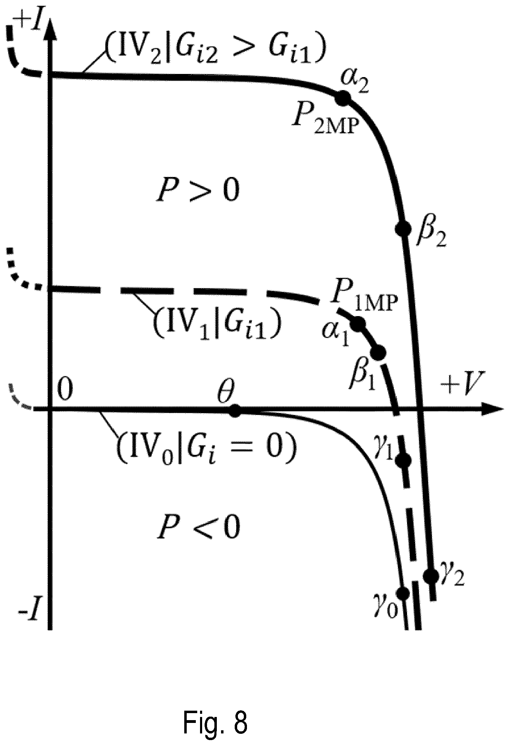

The high-voltage DC transmission line 10 is connected to at least one PCE 40 on the left- and/or right-hand side, coupling to an AC or DC grid 50, for instance other AC or DC sources or networks. With PCEs 40 on both sides, depending on the chosen voltage differences between the left- and right-hand side PCEs 40, the power flux direction is defined. In the case of Fig. 7, a power flux is assumed from right-to-left, with a higher transmitted power at circuit I than on circuit II. This is indicated by the number of arrows on each circuit, each arrow representing a certain amount of electric current flowing in the direction of the arrow(s). The number of arrows is directly proportional to the amount of electric current. In particular, Fig. 7 shows three (arbitrary) units of electric current on the right-hand side of circuit I and two units of electric current on the right-hand side of circuit II. In addition to the transmitted power, photovoltaic power generation is provided to the PCE 40 on the left-hand side of Fig. 7. Each pole receives two units of electric current, resulting in five units of electric current on the left-hand side of circuit I and four units of electric current on the left-hand side of circuit II. The operating points (see Fig. 8) of the PV array depend on the insulation and the voltage differences between the positive and negative poles to the neutral.

Below the double circuit bipolar high-voltage DC transmission line 10, the spatial distribution of the electric potential V(x) and the power P(x) is shown, each in arbitrary units. By way of example, if the voltage difference is assumed to be 10 kV, one arrow is assumed to represent 100 A of electric current, and no irradiance is applied to the PV arrays, then circuit I of the high-voltage DC transmission line 10 would transmit 300 A times 10 kV equals 3 MW per pole, resulting in 6 MW of electric power from the right-hand side PCE 40 to the left-hand side PCE 40. Similarly, circuit II would transmit 4 MW of power. The neutral pole does not transmit any current. On a sunny day, the PV modules 35 start generating power. Assuming that each high-voltage PV generator 30 generates 100 A of electric current at a potential difference of 10 kV, this would result in 1 MW of additional power. This is indicated by the double arrows at each direct connection 11 between a high-voltage output of the high-voltage PV generator 30 and a pole 12 of the high-voltage direct current transmission line 10. However, a more realistic amount of electric current per high-voltage PV generator 30 is 10 A, such that for the current flow as depicted in Fig. 7, each high-voltage PV generator 30 would actually have to be implemented ten times. This is indicated by the dashed lines at the far right- and left-hand sides of the PV arrays and the high-voltage DC transmission line 10. In the symmetrical conditions shown, an additional 200 A is fed in along the DC overhead line from the PV arrays on each positive and negative pole, which increases the power on both circuits I and II by 4 MW each, resulting in an increase on the left-hand side from 6 MW to 10 MW for circuit I and from 4 MW to 8 MW for circuit II. The connections of the neutral pole to the PCEs 40 are still de-energized, however an equalizing current flows to balance the currents of the left and right sides of the PV array chain. This current is symbolized here with a single arrow (100 A). If the high-voltage PV arrangement (with a current of 10 A per PV module 35) is repeated along the high-voltage direct current transmission line 10, the internal currents balance each other, and the residual balancing current would then not be 100 A but only 10 A.

Fig. 8 shows a current-voltage (IV) characteristic and power control strategies for a PV generator array or a parallel connection of arrays for three levels of irradiance. The horizontal axis displays voltage, and the vertical axis shows electric current, both in arbitrary units. The upper quadrant, where the current is positive, corresponds to PV power generation (indicated with *P* > 0), whereas the lower quadrant where the current is negative, corresponds to a PV array in power consumption mode (indicated with *P* < 0). The solid, dashed and thin curves correspond to IV characteristics for three levels of irradiance, *Gᵢ₂* > *Gᵢ₁* > *Gᵢ* = 0. The solid line, corresponding to a high irradiance IV characteristic, with three operating points indicated, *α*₂, *β*₂, and *γ*₂. The point *α*₂, is the maximum power operating point (MPP) with max. achievable power P_{2MP}; the point *β*₂ at higher voltage and much lower current is an operating point with reduced power generation in clipping mode (e.g. 70% of *P*_{2MP}), and operating point *γ*₂ with negative current, so called reverse bias, with the voltage greater than the open circuit voltage, resulting in a power consumption (e.g. -70% of P_{2MP}) of the PV generator(s). The dashed line corresponds to an operation at lower irradiance (e.g. with irradiance *G*ᵢ₁ = 35% of *G*ᵢ₂) with operating points *α*₁ at MPP (e.g. *P*_{1MP} approx. 30% of P_{2MP}) and *β*₁ reduced power (e.g. approx. 20% of *P*_{2MP}), and *γ*₁ reverse power (e.g. -20% of *P*_{2MP}). The thin solid line gives the dark IV curve (no irradiance, *G*ᵢ = 0), with operating point *θ* virtually without power consumption by the PV array(s), and point *γ*₀ in reverse bias power consumption mode (e.g. -70% of *P*_{2MP}).

The chosen voltage between the positive and negative pole of a system defines the operating point(s) of a PV generator array, which can optionally be fine-tuned with additional DC sources 45 (as can be seen in Fig. 6). The chosen voltage differences between the connections of the power conversion equipment 40 of the same system and polarity on the left- and right-hand side defines the transmitted current and power. The voltage at the positive and negative poles is variable, with their polarity kept unchanged, while the currents polarity is - depending on the voltage differences - changing, defining the power-flux direction and amount.

### Reference signs

- 10: high-voltage direct current transmission line
- 11: direct connection between a high-voltage output of the high-voltage PV generator and a pole of the high-voltage direct current transmission line
- 12: transmission pole
- 20: pylons
- 21: span length
- 30: high-voltage PV generator
- 31: series connection
- 32: series-parallel connection
- 33: mirror-symmetric arrangement (negative potential)
- 34: mirror-symmetric arrangement (positive potential)
- 35: PV module
- 40: DC/DC or DC/AC power conversion equipment (PCE)
- 45: additional DC source
- 50: AC or DC grid

## Claims

1. A System comprising a high-voltage direct current transmission line (10) carried by pylons (20), a high-voltage PV generator (30) connected to the high-voltage direct current transmission line (10), a power conversion equipment (40) with an input connected to the high-voltage direct current transmission line (10) and an output connectable to an AC or DC grid (50), comprising at least one of a point-source, a load and a network, **characterized in that** a high-voltage output of the high-voltage PV generator (30) is directly connected (11) to a transmission pole (12) of the high-voltage direct current transmission line (10).

2. The System according to claim 1, wherein the high-voltage PV generator (30) comprises at least one row of PV modules (35), wherein the PV modules (35) are directly serially connected (31) along a meandering arrangement.

3. The System according to claim 2, wherein the high-voltage PV generator (30) comprises two rows of PV modules (35), wherein the two rows are connected in parallel (32).

4. The System according to claim 2 or 3, wherein each row or the two parallelly connected rows form one array of the high-voltage PV generator (30), respectively, wherein the high-voltage PV generator (30) comprises at least two arrays, wherein the arrays are connected in a mirror-symmetric arrangement (33), (34) with regards to a direct current generator field.

5. The System according to any of claims 2 to 4, wherein the PV modules (35) are electrically connected via bare conductors.

6. The System according to any of claims 2 to 5, wherein the PV modules (35) are at least based on one of the following cell and interconnect technologies: bifacial, thin film, shingled, glued, soldered, welded.

7. The System according to any of claims 2 to 6, wherein the single PV modules (35) and/or the rows are directly connected (11) to the transmission poles (12) of the high-voltage direct current transmission line (10).

8. The System according to any of claims 2 to 7, further comprising additional direct current sources (45) at low voltage ends of the PV arrays.

9. The System according to any of claims 2 to 8, wherein the single PV modules (35) and/or the rows are connected to independent power lines or ropes, wherein the independent power lines or ropes are mechanically and/or electrically connected to the pylons (20) directly or by means of spacing insulators.

10. The System according to any of claims 1 to 9, wherein the output of the power conversion equipment (40) is connected to a high-voltage network (50).

11. The System according to any of claims 1 to 10, wherein the power conversion equipment (40) is a direct current to direct current inverter or a direct current to alternate current converter.

12. A high-voltage PV generator (30) directly connectable to a system according to any of claims 1 to 11, **characterized in that** the high-voltage PV generator (30) comprises at least one row of PV modules (35), wherein the PV modules (35) are directly serially connected along a meandering arrangement (31).

13. The high-voltage PV generator according to claim 12, wherein the high-voltage PV generator (30) comprises two rows of PV modules (35), wherein the high-voltage PV generator (30) comprises at least two arrays, wherein the arrays are connected in a mirror-symmetric arrangement (33), (34) with regards to a direct current generator field.

14. The high-voltage PV generator according to claim 12 or 13, wherein the PV modules (35) are electrically connected via bare conductors.

15. The high-voltage PV generator according to any of claims 12 to 14, wherein the PV modules (35) are at least based on one of the following cell and interconnect technologies: bifacial, thin film, shingled, glued, soldered, welded.
